# EUROPÄISCHE PATENTSCHRIFT

(11) **EP 3 485 573 B1**
(45) Veröffentlichungstag und Bekanntmachung des Hinweises auf die Patenterteilung: **01.07.2026**
(21) Anmeldenummer: 17780296.4
(22) Anmeldetag: 12.07.2017
(51) Int. Cl.: H03L 7/099, H03K 3/03, H03K 5/151

(54) **VORRICHTUNG UND VERFAHREN ZUM STEUERBAREN VERZOEGERN ELEKTRISCHER SIGNALE**
DEVICE AND METHOD FOR CONTROLLABLY DELAYING ELECTRICAL SIGNALS
DISPOSITIF ET PROCÉDÉ DE RETARDEMENT RÉGULABLE DE SIGNAUX ÉLECTRIQUES

(30) Priorität: 14.07.2016 DE 102016113031; 29.06.2017 DE 102017114602
(43) Veröffentlichungstag der Anmeldung: 22.05.2019
(73) Patentinhaber: EverProX Technologies Munich GmbH, 80687 München (DE)
(72) Erfinder: BLON, Thomas, 80687 Muenchen (DE)
(74) Vertreter: Hofmann, Andreas
(86) Internationale Anmeldenummer: PCT/DE2017/100578
(87) Internationale Veröffentlichungsnummer: WO 2018/010732

(56) Entgegenhaltungen:
- WO-A1-2007/101824
- US-A1- 2006 071 722
- US-A1- 2006 176 118
- WEI-HSUAN TU ET AL: "A 1.8V 2.5-5.2 GHz CMOS dual-input two-stage ring VCO", ADVANCED SYSTEM INTEGRATED CIRCUITS 2004. PROCEEDINGS OF 2004 IEEE ASI A-PACIFIC CONFERENCE ON FUKUOKA, JAPAN 4-5 AUG. 2004, PISCATAWAY, NJ, USA,IEEE, US, 4 August 2004 (2004-08-04), pages 134 - 137, XP010733847, ISBN: 978-0-7803-8637-2, DOI: 10.1109/APASIC.2004.1349429
- SAVOJ J ET AL: "A 10-GB/S CMOS CLOCK AND DATA RECOVERY CIRCUIT WITH A HALF-RATE LINEAR PHASE DETECTOR", IEEE JOURNAL OF SOLID-STATE CIRCUITS, IEEE SERVICE CENTER, PISCATAWAY, NJ, USA, vol. 36, no. 5, 1 May 2001 (2001-05-01), pages 761 - 768, XP001222889, ISSN: 0018-9200, DOI: 10.1109/4.918913

## Beschreibung

### Technisches Gebiet

Die vorliegende Erfindung betrifft grundsätzlich das technische Gebiet der Takt- und/oder Datenrückgewinnung (CDR = Clock and/or Data Recovery); insbesondere betrifft die vorliegende Erfindung eine Vorrichtung zum steuerbaren Verzögern eines elektrischen Signals (vgl. US 2006/0071722 A1) sowie einen Oszillatorring, aufweisend mindestens eine derartige Vorrichtung.

Des Weiteren betrifft die vorliegende Erfindung ein Verfahren zum Steuern des Verzögerns eines elektrischen Signals (vgl. WO 2007/101824 A1) sowie zu diesem Verzögern des elektrischen Signals mit mindestens einer derartigen Vorrichtung und/oder mit mindestens einem derartigen Oszillatorring.

Schließlich betrifft die vorliegende Erfindung die Verwendung mindestens einer derartigen Vorrichtung und/oder mindestens eines derartigen Oszillatorrings und/oder mindestens eines derartigen Verfahrens.

### Stand der Technik, insbesondere dessen Nachteile und technische Probleme

Zum technologischen Hintergrund der vorliegenden Erfindung wird zunächst auf die Dokumente
- A 1.8V 2.5-5.2 GHz CMOS dual-input two-stage ring VCO von Wei-Hsuan Tu et al., Proceedings of 2004 IEEE Asia-Pacific Conference on Advanced System Integrated Circuits in Fukuoka, Japan, August 2004, ISBN 978-0-7803-8637-2, Seiten 134 bis 137, und
- A 10-Gb/s CMOS clock and data recovery circuit with a half-rate linear phase detector von J. Savoj et al., IEEE Journal of Solid-State Circuits, Band 36, Nr 5, Mai 2001, ISSN 0018-9200, Seiten 761 bis 768
sowie auf die Druckschriften US 2006/0176118 A1, WO 2013/174377 A2 und WO 2013/189494 A2 aufmerksam gemacht.

In der Druckschrift WO 2013/174377 A2 sind eine Schaltungsanordnung und ein Verfahren zum Kalibrieren mindestens eines für einen spannungsgesteuerten Oszillator zur Takt- und Datenrückgewinnung vorgesehenen Ansteuersignals offenbart.

Hierbei wird insbesondere auf Schaltungen zur Takt- und Datenrückgewinnung oder CDR-Schaltungen mit binären Phasendetektoren Bezug genommen, wobei der Phasendetektor zwei digitale Phasendetektor-Ausgangssignale "up" (für beschleunigend) und "down" (für verzögernd) abgeben kann.

Die Schaltungsanordnung gemäß der Druckschrift WO 2013/174377 A2 geht hierbei von einem spannungsgesteuerten Ringoszillator mit zwei Tuning-Eingängen aus, dessen Frequenz über die beiden Tuning-Eingänge separat eingestellt werden kann. Hierbei wird die Frequenzänderung durch vier separate Varaktor(diod)en eingestellt.

Als nachteilig wird bei diesem Oszillator seine niedrige Ausgangsfrequenz bezeichnet, denn es sind vier Varaktoren erforderlich, so dass mehr parasitäre Kapazität im Oszillator erzeugt wird.

Um die Ausgangsfrequenz möglichst zu vergrößern, wird gemäß der Druckschrift WO 2013/174377 A2 vorgeschlagen, die Schaltungsanordnung zum Kalibrieren des für einen spannungsgesteuerten Oszillator zur Takt- und Datenrückgewinnung vorgesehenen Ansteuersignals mit mindestens einem Kalibrierungsoszillator, mindestens einem dem Kalibrierungsoszillator zugeordneten Referenzoszillator, mindestens einem dem Kalibrierungsoszillator und dem Referenzoszillator nachgeschalteten Taktzähler und mindestens einem dem Taktzähler nachgeschalteten Digital-Analog-Wandler auszubilden, wobei der Taktzähler zum Zählen der jeweiligen Taktanzahl des Kalibrierungsoszillators und des Referenzoszillators sowie zum Integrieren eines sich aus der Differenz dieser beiden Taktanzahlen ergebenden Taktfehlers und der Digital-Analog-Wandler zum Wandeln des Taktfehles in analoge Tuningsignale, aus denen das kalibrierte Ansteuersignal ableitbar ist, ausgebildet ist.

Hierbei wird der spannungsgesteuerte Oszillator derart angesteuert, dass im spannungsgesteuerten Oszillator nicht mehr vier, sondern nur noch zwei Varaktor(diod)en benötigt werden, wobei die Frequenzänderung nicht mehr mit zwei Ansteuersignalen, sondern nur noch mit einem Ansteuersignal erzielt wird, sowohl der Referenzoszillator als auch der Kalibrierungsoszillator jedoch auch weiterhin jeweils vier Varaktor(diod)en enthalten.

Aus der Druckschrift WO 2013/189494 A2 sind eine Schaltungsanordnung und ein Verfahren zur Takt- und/oder Datenrückgewinnung bekannt, wobei ein spannungsgesteuerter Ringoszillator eingesetzt wird. Ein solcher Ringoszillator, der in Form von vier spannungsgesteuerten Oszillator-Pufferstufen implementiert ist, sowie Implementierungen derartiger spannungsgesteuerter Oszillator-Pufferstufen sind dargestellt.

Eine derartige spannungsgesteuerte Oszillator-Pufferstufe weist vier Varaktoren auf, deren Kapazitätswerte über zwei den paarweise verbundenen anodischen Anschlüssen der Varaktoren zuführbare Abstimmspannungen up und dnb einstellbar sind und die Schwingfrequenz des Ringoszillators bestimmen.

Die Varaktoren dienen mit ihrer kapazitiven Last als frequenz(mit)bestimmende Elemente der Frequenzvariation.

Da insbesondere zwei leicht voneinander unterschiedliche Spannungen eingestellt werden sollen, werden die Varaktoren in zwei Arbeitspunkten betrieben:
- Arbeitspunkt mit geringer Kapazität;
- Arbeitspunkt mit großer Kapazität.

Soll keine Frequenzvariation nach oben oder unten stattfinden, so werden die Varaktoren in einem Arbeitspunkt mittlerer Kapazität betrieben. Diese Kapazität reduziert aber die maximal erreichbare Frequenz des Oszillators.

Darüber hinaus bringt das Einfügen der Varaktoren in den Signalpfad des Oszillators allein schon durch die zusätzliche Verdrahtung eine Erhöhung parasitärer kapazitiver Lasten mit sich, die ebenfalls die maximal erreichbare Frequenz des Oszillators reduzieren.

### Darstellung der vorliegenden Erfindung: Aufgabe, Lösung, Vorteile; bester Weg zur Ausführung der vorliegenden Erfindung

Ausgehend von den vorstehend dargelegten Nachteilen und Unzulänglichkeiten sowie unter Würdigung des umrissenen Standes der Technik liegt der vorliegenden Erfindung die Aufgabe zugrunde, parasitäre kapazitive Lasten zu vermeiden oder zumindest zu verringern.

Erfindungsgemäß wird diese Aufgabe durch eine Vorrichtung mit den Merkmalen des Anspruchs 1, durch einen Oszillatorring mit den Merkmalen des Anspruchs 12 sowie durch ein Verfahren mit den Merkmalen des Anspruchs 13 gelöst. Vorteilhafte Ausgestaltungen und zweckmäßige Weiterbildungen der vorliegenden Erfindung sind in den jeweiligen Unteransprüchen gekennzeichnet.

Die vorliegende Erfindung stellt mit anderen Worten eine Vorrichtung zum steuerbaren Verzögern eines elektrischen Signals mit
- einem ersten Signalübertragungspfad zwischen einem Signaleingang und einem Signalausgang, umfassend
   - eine erste Signalübertragungsstufe mit einem ersten Differenzpaar, insbesondere emitter- bzw. sourcegekoppelter Transistoren, und einer gemeinsamen, einstellbaren ersten Ruhestromquelle,
- einem zweiten Signalübertragungspfad zwischen dem Signaleingang und dem Signalausgang, umfassend
   - eine zweite Signalübertragungsstufe mit einem zweiten Differenzpaar, insbesondere emitter- bzw. sourcegekoppelter Transistoren, und einer gemeinsamen, einstellbaren zweiten Ruhestromquelle sowie
   - eine zwischen dem Signaleingang und der zweiten Signalübertragungsstufe angeordnete interne Verzögerungsstufe mit einem dritten Differenzpaar, insbesondere emitter- bzw. sourcegekoppelter Transistoren, und einer gemeinsamen, einstellbaren dritten Ruhestromquelle, und
- einer Signalverknüpfungsstufe zum additiven Überlagern des über den ersten Signalübertragungspfad übertragenen elektrischen Signals mit dem über den zweiten Signalübertragungspfad übertragenen elektrischen Signal,
bereit.

Gemäß der vorliegenden Erfindung wird die vorstehende Aufgabe gelöst durch eine Vorrichtung mit einer ersten Strommodulationsstufe zum Einstellen des Ruhestroms der ersten Ruhestromquelle, nämlich zum Einspeisen eines zusätzlichen Stroms in eine Ruhestromeinstellung der ersten Ruhestromquelle, und einer zweiten Strommodulationsstufe zum Einstellen des Ruhestroms der dritten Ruhestromquelle, nämlich zum Einspeisen eines zusätzlichen Stroms in eine Ruhestromeinstellung der dritten Ruhestromquelle.

Nach einer weiteren vorteilhaften Ausgestaltung der vorliegenden Erfindung wird die vorstehende Aufgabe auch gelöst durch eine Vorrichtung mit einer dritten Strommodulationsstufe zum Einstellen des Ruhestroms der zweiten Ruhestromquelle.

In der vorliegenden Erfindung wird die vorstehende Aufgabe gelöst durch eine Vorrichtung, die dadurch gekennzeichnet ist, dass die erste und zweite Strommodulationsstufe jeweils mit
- einem ersten Strommodulations-Differenzpaar, insbesondere emitter- bzw. sourcegekoppelter Transistoren, und einer dem ersten Strommodulations-Differenzpaar gemeinsamen, einstellbaren ersten Strommodulations-Ruhestromquelle und
- einem zweiten Strommodulations-Differenzpaar, insbesondere emitter- bzw. sourcegekoppelter Transistoren, und einer dem zweiten Strommodulations-Differenzpaar gemeinsamen, einstellbaren zweiten Strommodulations-Ruhestromquelle
   ausgebildet ist, wobei
- dem ersten Strommodulations-Differenzpaar als ein erstes Steuersignal ein diskretisiertes Signal zur Frequenzerhöhung und
- dem zweiten Strommodulations-Differenzpaar als ein zweites Steuersignal ein diskretisiertes Signal zur Frequenzreduzierung
zuführbar ist und die erste und die zweite Strommodulations-Ruhestromquelle jeder Strommodulationsstufe gemeinsam einstellbar sind.

Vorteilhaft wird nach einer weiteren Ausgestaltung der vorliegenden Erfindung die vorstehende Aufgabe gelöst durch eine Vorrichtung, bei der die erste und zweite und dritte Strommodulationsstufe zum Einspeisen jeweils eines zusätzlichen Stroms in die Ruhestromeinstellung der ersten bzw. zweiten bzw. dritten Ruhestromquelle ausgebildet ist bzw. sind.

Nach einer anderen vorteilhaften Ausgestaltung der vorliegenden Erfindung wird die vorstehende Aufgabe gelöst durch eine Vorrichtung, die dadurch gekennzeichnet ist, dass in der ersten bzw. zweiten bzw. dritten Strommodulationsstufe jeweils die erste und die zweite Strommodulations-Ruhestromquelle zum durch das erste und zweite Steuersignal gesteuerten Einspeisen des jeweils zusätzlichen Stroms in eine Ruhestromeinstellung der ersten bzw. zweiten bzw. dritten Ruhestromquelle ausgebildet sind.

Die vorstehende Aufgabe wird ferner gelöst durch einen Oszillatorring, der mindestens eine Vorrichtung der vorstehend dargelegten Art aufweist.

Weiterhin wird die vorstehende Aufgabe gelöst durch ein Verfahren zum Steuern des Verzögerns eines elektrischen Signals sowie zu diesem Verzögern des elektrischen Signals mit mindestens einer Vorrichtung der vorstehend dargelegten Art, wobei dieses Verfahren dadurch gekennzeichnet ist, dass
- der ersten und zweiten Strommodulationsstufe jeweils
   - ein diskretisiertes Signal zur Frequenzerhöhung mindestens eines Oszillatorrings der vorstehend dargelegten Art als ein erstes Steuersignal und
   - ein diskretisiertes Signal zur Frequenzreduzierung des Oszillatorrings als ein zweites Steuersignal zugeführt werden,
- gesteuert durch das erste und zweite Steuersignal, in der ersten und zweiten Strommodulationsstufe jeweils ein zusätzlicher Strom erzeugt wird und
- der jeweils zusätzliche Strom der ersten und zweiten Strommodulationsstufe in eine Ruhestromeinstellung der ersten bzw. dritten Ruhestromquelle eingespeist wird zum Einstellen des Ruhestroms der ersten bzw. dritten Ruhestromquelle.

Die vorstehende Aufgabe wird außerdem gelöst durch eine Verwendung mindestens einer Vorrichtung der vorstehend dargelegten Art und/oder eines Verfahrens der vorstehend dargelegten Art bei der Takt- und/oder Datenrückgewinnung mit mindestens einem digitalen Phasendetektor, wobei vom mindestens einen digitalen Phasendetektor ein diskretisiertes Signal zur Frequenzerhöhung mindestens eines Oszillatorrings der vorstehend dargelegten Art als ein erstes Steuersignal und/oder ein diskretisiertes Signal zur Frequenzreduzierung des Oszillatorrings als ein zweites Steuersignal zugeführt werden.

Hinsichtlich exemplarischer technischer Einsatzgebiete des vorliegenden Oszillators mit Frequenzumschaltung ist insbesondere für Anwendungen in Taktrückgewinnungsschaltungen (CDR = Clock and/or Data Recovery) mit binärem Phasendetektor zu berücksichtigen, dass nur geringe Frequenzvariationen gegenüber einer mittleren Frequenz nötig sind, so dass hier vorteilhafterweise die gewünschte Frequenzvariation allein mit der leichten Variation des Betriebsstroms der Oszillatordifferenzstufen, das heißt der ersten und/oder der zweiten Signalübertragungsstufe, bzw. der internen Verzögerungsstufe erreicht werden kann.

Weitere exemplarische technische Anwendungsgebiete sind:
- Oszillatoren für CDR (Clock and/or Data Recovery) mit digitalem Phasendetektor;
- Taktrückgewinnung im Empfänger eines seriellen Datenstroms, wenn der Datentakt im Datenstrom eingebettet ist, also keine lokale Taktreferenz zur Verfügung steht; oder
- Oszillatoren für digitale PLL (Phase Locked Loop, zur Frequenzsynthese) mit digitalem Phasendetektor.

### Kurze Beschreibung der Zeichnungen

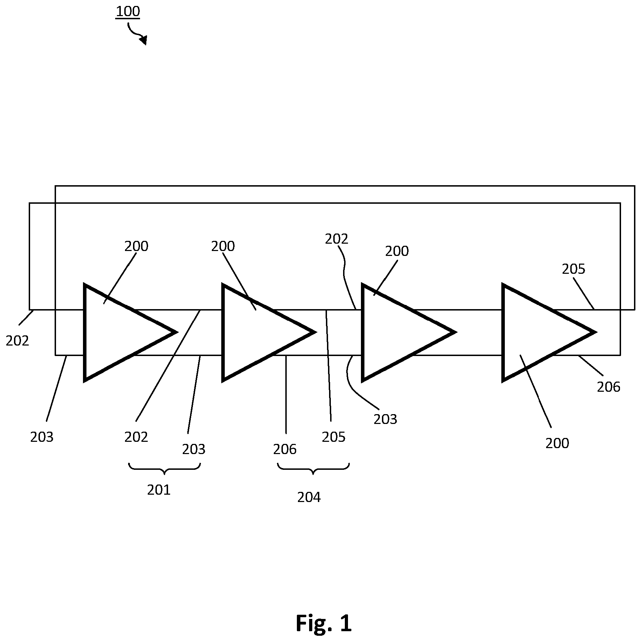

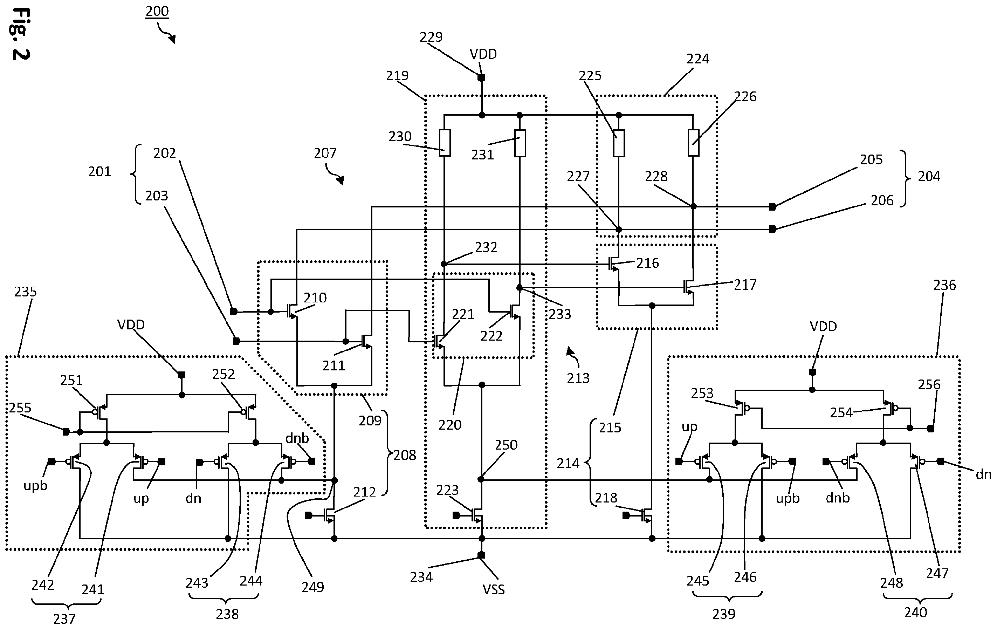

Wie bereits vorstehend erörtert, gibt es verschiedene Möglichkeiten, die Lehre der vorliegenden Erfindung in vorteilhafter Weise auszugestalten und weiterzubilden. Hierzu wird einerseits auf die dem Anspruch 1 nachgeordneten Ansprüche verwiesen, andererseits werden weitere Ausgestaltungen, Merkmale und Vorteile der vorliegenden Erfindung nachstehend unter anderem anhand der durch Fig. 1 und Fig. 2 veranschaulichten Ausführungsbeispiele näher erläutert.

### Es zeigt:

- Fig. 1: ein Prinzipschaltbild eines Ausführungsbeispiels eines Oszillatorrings gemäß der vorliegenden Erfindung, aufweisend mehrere identische Verzögerungsstufen; und
- Fig. 2: ein detailliertes Prinzipschaltbild eines Ausführungsbeispiels einer dieser Verzögerungsstufen gemäß der vorliegenden Erfindung.

Gleiche, ähnliche oder übereinstimmende Ausgestaltungen, Elemente oder Merkmale sind in Fig. 1 und in Fig. 2 mit denselben Bezugszeichen versehen; es wird auf eine wiederholte Beschreibung dieser Ausgestaltungen, Elemente oder Merkmale verzichtet.

### Bevorzugte Ausführungsform der Erfindung; bester Weg zur Ausführung der vorliegenden Erfindung

An dieser Stelle sei erwähnt, dass eine Verzögerungsstufe, aufgebaut mit nur einem ersten Differenzpaar und einem zweiten Differenzpaar, sowie einer internen Verzögerungsstufe und einer gemeinsamen resistiven Last, dem Stand der Technik entspricht, dargestellt zum Beispiel in der Monographie von Behzad Razavi, "Design of Analog CMOS Integrated Circuits", Seiten 518 und 519, Fig. 14.48 und Fig. 14.49, im Allgemeinen bekannt als interpolierende Verzögerungsstufe:
Gemäß Fig. 14.48(a) und Fig. 14.49(b) weisen das erste Differenzpaar, das zweite Differenzpaar sowie die interne Verzögerungsstufe jeweils eine durch eine Steuerspannung V_{cont} gesteuerte Ruhestromquelle I_{SS} auf, wobei die Steuerspannung und damit der Ruhestrom der Ruhestromquelle des ersten Differenzpaars in entgegengesetzter Richtung zu der Steuerspannung und damit den Ruheströmen der Ruhestromquellen des zweiten Differenzpaars sowie der internen Verzögerungsstufe variiert.

Hierdurch variiert die Verzögerung der interpolierenden Verzögerungsstufe insgesamt durch Variation der Steuerspannung zwischen den Extremwerten, die durch die Verzögerungen des ersten Differenzpaars einerseits - des schnellen, ersten Signalübertragungspfads - und der Zusammenschaltung des zweiten Differenzpaars mit der internen Verzögerungsstufe andererseits - des langsamen, zweiten Signalübertragungspfads - bestimmt werden.

Die damit erzielte Frequenzvariation zwischen der minimalen Schwingfrequenz eines mit einer solchen interpolierenden Verzögerungsstufe aufgebauten Ringoszillators, wenn nur der langsame, zweite Signalübertragungspfad eingeschaltet ist, und seiner maximalen Schwingfrequenz, wenn nur der schnelle, erste Signalübertragungspfad eingeschaltet ist, geht jedoch weit über die vorgenannten, nur geringen Frequenzvariationen gegenüber einer mittleren Frequenz hinaus.

Dem erfindungsgemäß hinzugefügt werden Strommodulationsstufen zum Einstellen der Ruheströme mindestens einer der Ruhestromquellen, das heißt zum Einstellen
- des Ruhestroms der Ruhestromquelle des ersten Differenzpaars der ersten Signalübertragungsstufe - in der Ausführung der vorliegenden Erfindung als erste Ruhestromquelle bezeichnet,
   und/oder
- des Ruhestroms der Ruhestromquelle des zweiten Differenzpaars der zweiten Signalübertragungsstufe - in der Ausführung der vorliegenden Erfindung als zweite Ruhestromquelle bezeichnet,
   und/oder
- des Ruhestroms der Ruhestromquelle des dritten Differenzpaars der internen Verzögerungsstufe - in der Ausführung der vorliegenden Erfindung als dritte Ruhestromquelle bezeichnet.

Vorteilhafterweise angeordnet werden diese weiteren Differenzstufen als eine erste Strommodulationsstufe zum Einstellen des Ruhestroms der ersten Ruhestromquelle (= erste Strommodulation) und als eine zweite Strommodulationsstufe zum Einstellen des Ruhestroms der dritten Ruhestromquelle (= zweite Strommodulation) zur Modulation des Ruhestroms des ersten Differenzpaars (= erste Strommodulation) bzw. der internen Verzögerungsstufe (= zweite Strommodulation), wie in Fig. 2 wiedergegeben.

In einer anderen, in den Figuren nicht dargestellten Ausführungsform der vorliegenden Erfindung werden diese weiteren Differenzstufen vorteilhaft angeordnet als die erste Strommodulationsstufe zum Einstellen des Ruhestroms der ersten Ruhestromquelle (= erste Strommodulation) und als eine dritte Strommodulationsstufe zum Einstellen des Ruhestroms der zweiten Ruhestromquelle (= dritte Strommodulation) zur Modulation des Ruhestroms des ersten Differenzpaars (= erste Strommodulation) bzw. des zweiten Differenzpaars (= dritte Strommodulation).

Eine noch andere, ebenfalls in den Figuren nicht dargestellte Ausführungsform der vorliegenden Erfindung umfasst eine erste Strommodulationsstufe zum Einstellen des Ruhestroms der ersten Ruhestromquelle (= erste Strommodulation), eine zweite Strommodulationsstufe zum Einstellen des Ruhestroms der dritten Ruhestromquelle (= zweite Strommodulation) und eine dritte Strommodulationsstufe zum Einstellen des Ruhestroms der zweiten Ruhestromquelle (= dritte Strommodulation).

Die Vorrichtungen gemäß den Figuren der Zeichnung werden nun näher beschrieben, wobei übereinstimmende Zeichnungselemente dieselben Bezugszeichen tragen und zur Vermeidung überflüssiger Wiederholungen auf eine wiederholte Beschreibung dieser Zeichnungselemente verzichtet ist. Die nachfolgenden Erläuterungen beziehen sich hinsichtlich der Ausgestaltungen, Merkmale und Vorteile der vorliegenden Erfindung also - soweit nicht anderweitig angegeben - auf alle anhand Fig. 1 und Fig. 2 veranschaulichten Ausführungsbeispiele der vorliegenden Erfindung:
Fig. 1 zeigt als Ausführungsbeispiel einen Oszillatorring bzw. Ringoszillator 100, aufweisend mehrere - hier vier - identische Verzögerungsstufen 200:
Als eine derartige Verzögerungsstufe 200 ist nachfolgend die erfindungsgemäße Vorrichtung zum steuerbaren Verzögern eines elektrischen Signals bezeichnet. Die Verzögerungsstufe 200 ist zum Beispiel als interpolierende Verzögerungsstufe 200 aufgebaut, wie nachfolgend anhand der Fig. 2 gezeigt ist.

Jede der vier Verzögerungsstufen 200 weist einen differenziellen Eingang 201 mit zwei Eingangsanschlüssen 202, 203 und einen differenziellen Ausgang 204 mit zwei Ausgangsanschlüssen 205, 206 auf.

Ein dem differenziellen Eingang 201 zugeführtes, elektrisches Signal wird mit definierter, einstellbarer Verzögerung am differenziellen Ausgang 204 abgegeben. Für dieses elektrische Signal bildet die Verzögerungsstufe 200 einen elektrischen Vierpol.

Vier dieser Vierpole, also die vier Verzögerungsstufen 200, sind in Fig. 1 in Kettenschaltung miteinander verbunden, wobei der differenzielle Ausgang 204 einer ersten, das heißt in der Kettenschaltung voraufgehenden, der Verzögerungsstufen 200 mit dem differenziellen Eingang 201 einer zweiten, das heißt in der Kettenschaltung nachfolgenden, der Verzögerungsstufen 200 verbunden ist.

An einem Ende der Kettenschaltung ist der differenzielle Ausgang 204 der letzten der Verzögerungsstufen 200 mit dem differenziellen Eingang 201 der ersten der Verzögerungsstufen 200 über Kreuz verbunden. Hierdurch wird zum einen der Oszillatorring gebildet und zum anderen das elektrische Signal vom differenziellen Ausgang 204 der letzten der Verzögerungsstufen 200 in vertauschter Polarität dem differenziellen Eingang 201 der ersten der Verzögerungsstufen 200 zugeführt.

Auf diese Weise durchläuft das elektrische Signal die Kettenschaltung in wechselweiser Polarität und oszilliert hierdurch an den differenziellen Eingängen 201 bzw. den differenziellen Ausgängen 204 mit einer durch die Summe der Verzögerungen aller Verzögerungsstufen 200 der Kettenschaltung bestimmten Frequenz.

Fig. 2 zeigt im Detail eine dieser Verzögerungsstufen 200 gemäß einem Ausführungsbeispiel der vorliegenden Erfindung:
Die Verzögerungsstufe 200 gemäß Fig. 2 ist ausgestaltet mit einem ersten Signalübertragungspfad 207 zwischen dem als differenzieller Eingang 201 ausgebildeten Signaleingang der Verzögerungsstufe 200 und dem als differenzieller Ausgang 204 ausgebildeten Signalausgang der Verzögerungsstufe 200.

Der erste Signalübertragungspfad 207 umfasst eine erste Signalübertragungsstufe 208 mit einem ersten Differenzpaar 209 sourcegekoppelter Transistoren 210, 211 und einer gemeinsamen, einstellbaren ersten Ruhestromquelle 212. Die Verzögerungsstufe 200 ist ferner ausgestaltet mit einem zweiten Signalübertragungspfad 213 zwischen dem differenziellen Eingang 201 und dem differenziellen Ausgang 204.

Der zweite Signalübertragungspfad 213 umfasst eine zweite Signalübertragungsstufe 214 mit einem zweiten Differenzpaar 215 sourcegekoppelter Transistoren 216, 217 und einer gemeinsamen, einstellbaren zweiten Ruhestromquelle 218 sowie eine zwischen dem differenziellen Eingang 201 und der zweiten Signalübertragungsstufe 214 angeordnete interne Verzögerungsstufe 219 mit einem dritten Differenzpaar 220 sourcegekoppelter Transistoren 221, 222 und einer gemeinsamen, einstellbaren dritten Ruhestromquelle 223.

Alle Transistoren des ersten Signalübertragungspfads 207 und des zweiten Signalübertragungspfads 213, also der erste und der zweite sourcegekoppelte Transistor 210, 211 des ersten Differenzpaars 209 sowie die diesem gemeinsame, einstellbare erste Ruhestromquelle 212, der erste und der zweite sourcegekoppelte Transistor 216, 217 des zweiten Differenzpaars 215 sowie die diesem gemeinsame, einstellbare zweite Ruhestromquelle 218 und der erste und der zweite sourcegekoppelte Transistor 221, 222 des dritten Differenzpaars 220 sowie die diesem gemeinsame, einstellbare dritte Ruhestromquelle 223, sind im dargestellten Ausführungsbeispiel der vorliegenden Erfindung als NMOS-Feldeffekttransistoren ausgebildet.

Die Verzögerungsstufe 200 ist weiterhin ausgestaltet mit einer Signalverknüpfungsstufe 224 zum additiven Überlagern des über den ersten Signalübertragungspfad 207 übertragenen elektrischen Signals mit dem über den zweiten Signalübertragungspfad 213 übertragenen elektrischen Signal.

Hierzu ist die Signalverknüpfungsstufe 224 mit einer dem ersten Differenzpaar 209 der ersten Signalübertragungsstufe 208 und dem zweiten Differenzpaar 215 der zweiten Signalübertragungsstufe 214 gemeinsamen, einen ersten Arbeitswiderstand 225 und einen zweiten Arbeitswiderstand 226 umfassenden resistiven Last ausgebildet.

Der erste Arbeitswiderstand 225 der Signalverknüpfungsstufe 224 ist einerseits mit einem ersten Verbindungspunkt 227 der Drainanschlüsse des ersten sourcegekoppelten Transistors 210 des ersten Differenzpaars 209 der ersten Signalübertragungsstufe 208 und des ersten sourcegekoppelten Transistors 216 des zweiten Differenzpaars 215 der zweiten Signalübertragungsstufe 214 und anderseits mit einem ein erstes Versorgungsspannungspotential VDD führenden ersten Versorgungsspannungsanschluss 229 verbunden.

Der zweite Arbeitswiderstand 226 der Signalverknüpfungsstufe 224 ist einerseits mit einem zweiten Verbindungspunkt 228 der Drainanschlüsse des zweiten sourcegekoppelten Transistors 211 des ersten Differenzpaars 209 der ersten Signalübertragungsstufe 208 und des zweiten sourcegekoppelten Transistors 217 des zweiten Differenzpaars 215 der zweiten Signalübertragungsstufe 214 und anderseits mit dem ersten Versorgungsspannungsanschluss 229 verbunden.

Der erste und zweite Verbindungspunkt 227, 228 bilden jeweils einen Stromknoten für die additive Überlagerung der Ströme in den Drainanschlüssen der ersten sourcegekoppelten Transistoren 210, 216 bzw. der zweiten sourcegekoppelten Transistoren 211, 217.

An den Arbeitswiderständen tritt dann jeweils eine den additiv überlagerten Strömen in den Drainanschlüssen proportionale Spannung auf; beide Spannungen bilden zusammen ein differenzielles Signal am differenziellen Ausgang 204 der Verzögerungsstufe 200.

Auch die interne Verzögerungsstufe 219 umfasst zwei Arbeitswiderstände, und zwar einen dritten Arbeitswiderstand 230, der einerseits mit einem dritten Verbindungspunkt 232 des Drainanschlusses des ersten sourcegekoppelten Transistors 221 des dritten Differenzpaars 220 der internen Verzögerungsstufe 219 und des Gateanschlusses des ersten sourcegekoppelten Transistors 216 des zweiten Differenzpaars 215 der zweiten Signalübertragungsstufe 214 und anderseits mit dem ersten Versorgungsspannungsanschluss 229 verbunden ist, sowie einen vierten Arbeitswiderstand 231, der einerseits mit einem vierten Verbindungspunkt 233 des Drainanschlusses des zweiten sourcegekoppelten Transistors 222 des dritten Differenzpaars 220 der internen Verzögerungsstufe 219 und des Gateanschlusses des zweiten sourcegekoppelten Transistors 217 des zweiten Differenzpaars 215 der zweiten Signalübertragungsstufe 214 und anderseits mit dem ersten Versorgungsspannungsanschluss 229 verbunden ist.

Die erste Ruhestromquelle 212 ist einerseits mit den miteinander verbundenen Sourceanschlüssen des ersten Differenzpaars 209 sourcegekoppelter Transistoren 210, 211 der ersten Signalübertragungsstufe 208 und anderseits mit einem ein zweites Versorgungsspannungspotential VSS führenden zweiten Versorgungsspannungsanschluss 234 verbunden.

Die zweite Ruhestromquelle 218 ist einerseits mit den miteinander verbundenen Sourceanschlüssen des zweiten Differenzpaars 215 sourcegekoppelter Transistoren 216, 217 der zweiten Signalübertragungsstufe 214 und anderseits mit dem zweiten Versorgungsspannungsanschluss 234 verbunden.

Die dritte Ruhestromquelle 218 ist einerseits mit den miteinander verbundenen Sourceanschlüssen des dritten Differenzpaars 220 sourcegekoppelter Transistoren 221, 222 der internen Verzögerungsstufe 219 und anderseits mit dem zweiten Versorgungsspannungsanschluss 234 verbunden.

Vorteilhaft sind die Ruhestromeinstellungen der Ruhestromquellen 212, 218, 223 für das erste, zweite bzw. dritte Differenzpaar 209, 215 bzw. 220 durch den Gateanschlüssen der die Ruhestromquellen 212, 218 bzw 223 bildenden NMOS-Feldeffekttransistoren zuzuführende Steuerspannungen vornehmbar; insbesondere ist als zweites Versorgungsspannungspotential VSS Massepotential und als erstes Versorgungsspannungspotential VDD ein gegenüber Masse positives Spannungspotential gewählt.

Gemäß dem beschriebenen Ausführungsbeispiel ist die Vorrichtung nach Fig. 2, das heißt die Verzögerungsstufe 200, ausgebildet mit einer ersten Strommodulationsstufe 235 zum Einstellen des Ruhestroms der ersten Ruhestromquelle 212 und einer zweiten Strommodulationsstufe 236 zum Einstellen des Ruhestroms der dritten Ruhestromquelle 223.

In einer nicht dargestellten Abwandlung dieses Ausführungsbeispiels kann zusätzlich eine dritte Strommodulationsstufe zum Einstellen des Ruhestroms der zweiten Ruhestromquelle 218 vorgesehen sein, wobei diese dritte Strommodulationsstufe in ihrem Aufbau zumindest weitgehend mit demjenigen der ersten Strommodulationsstufe 235 und der zweiten Strommodulationsstufe 236 übereinstimmt.

Ferner sind Abwandlungen möglich, bei denen entweder nur die erste, zweite oder dritte Strommodulationsstufe vorgesehen ist, oder nur die erste und die dritte Strommodulationsstufe, oder nur die zweite und die dritte Strommodulationsstufe. Alle diese Abwandlungen lösen die Aufgabe der vorliegenden Erfindung. Exemplarisch wird hier nur die Ausführung gemäß Fig. 2 beschrieben.

Im Ausführungsbeispiel nach Fig. 2 sind die erste Strommodulationsstufe 235 und die zweite Strommodulationsstufe 236 identisch aufgebaut. Jede der beiden Strommodulationsstufen 235, 236 umfasst jeweils eine erste Differenzstufe 237 bzw. 239 und jeweils eine zweite Differenzstufe 238 bzw. 240 pro zwei sourcegekoppelten Transistoren 241 und 242 bzw. 245 und 246 bzw. 243 und 244 bzw. 247 und 248.

Hierbei sind die Drainanschlüsse des zweiten sourcegekoppelten Transistors 242 der ersten Differenzstufe 237 der ersten Strommodulationsstufe 235 und des ersten sourcegekoppelten Transistors 243 der zweiten Differenzstufe 238 der ersten Strommodulationsstufe 235 sowie des zweiten sourcegekoppelten Transistors 246 der ersten Differenzstufe 239 der zweiten Strommodulationsstufe 236 und des ersten sourcegekoppelten Transistors 247 der zweiten Differenzstufe 240 der zweiten Strommodulationsstufe 236 mit dem das zweite Versorgungsspannungspotential VSS führenden zweiten Versorgungsspannungsanschluss 234 verbunden.

Die Drainanschlüsse des ersten sourcegekoppelten Transistors 241 der ersten Differenzstufe 237 der ersten Strommodulationsstufe 235 und des zweiten sourcegekoppelten Transistors 244 der zweiten Differenzstufe 238 der ersten Strommodulationsstufe 235 sind miteinander und mit einem fünften Verbindungspunkt 249 der gekoppelten Sourceanschlüsse des ersten sourcegekoppelten Transistors 210 und des zweiten sourcegekoppelten Transistors 211 des ersten Differenzpaars 209 der ersten Signalübertragungsstufe 208 mit der ersten Ruhestromquelle 212 zum ersten Differenzpaar 209 der ersten Signalübertragungsstufe 208 verbunden.

Die Drainanschlüsse des ersten sourcegekoppelten Transistors 245 der ersten Differenzstufe 239 der zweiten Strommodulationsstufe 236 und des zweiten sourcegekoppelten Transistors 248 der zweiten Differenzstufe 240 der zweiten Strommodulationsstufe 236 sind miteinander und mit einem sechsten Verbindungspunkt 250 der gekoppelten Sourceanschlüsse des ersten sourcegekoppelten Transistors 221 und des zweiten sourcegekoppelten Transistors 222 des dritten Differenzpaars 220 der internen Verzögerungsstufe 219 mit der dritten Ruhestromquelle 223 zum dritten Differenzpaar 220 der internen Verzögerungsstufe 219 verbunden.

In der ersten Strommodulationsstufe 235 sind die Sourceanschlüsse des ersten sourcegekoppelten Transistors 241 und des zweiten sourcegekoppelten Transistors 242 der ersten Differenzstufe 237 miteinander und mit dem Drainanschluss eines Transistors verbunden, mit dem eine von der ersten Strommodulationsstufe 235 umfasste vierte Ruhestromquelle 251 gebildet ist, und sind weiterhin die Sourceanschlüsse des ersten sourcegekoppelten Transistors 243 und des zweiten sourcegekoppelten Transistors 244 der zweiten Differenzstufe 238 miteinander und mit dem Drainanschluss eines Transistors verbunden, mit dem eine von der ersten Strommodulationsstufe 235 umfasste fünfte Ruhestromquelle 252 gebildet ist.

Die Sourceanschlüsse der Transistoren, mit denen die vierte und die fünfte Ruhestromquelle 251, 252 gebildet sind, sind mit dem das erste Versorgungsspannungspotential VDD führenden ersten Versorgungsspannungsanschluss 229 verbunden.

Die Gateanschlüsse der Transistoren, mit denen die vierte und die fünfte Ruhestromquelle 251, 252 gebildet sind, sind mit einem gemeinsamen Steuerspannungsanschluss 255 verbunden, über den der vierten und der fünften Ruhestromquelle 251, 252 im Betrieb eine gemeinsame Steuerspannung zum Einstellen eines, insbesondere übereinstimmenden, Ruhestroms in der vierten und der fünften Ruhestromquelle 251, 252 zugeführt wird. Die vierte und die fünfte Ruhestromquelle 251, 252 weisen somit eine gemeinsame Ruhestromeinstellung durch die gemeinsame Steuerspannung an den Gateanschlüssen auf.

In gleicher Weise sind in der zweiten Strommodulationsstufe 236 die Sourceanschlüsse des ersten sourcegekoppelten Transistors 245 und des zweiten sourcegekoppelten Transistors 246 der ersten Differenzstufe 239 miteinander und mit dem Drainanschluss eines Transistors verbunden, mit dem eine von der zweiten Strommodulationsstufe 236 umfasste sechste Ruhestromquelle 253 gebildet ist, und sind ferner die Sourceanschlüsse des ersten sourcegekoppelten Transistors 247 und des zweiten sourcegekoppelten Transistors 248 der zweiten Differenzstufe 240 miteinander und mit dem Drainanschluss eines Transistors verbunden, mit dem eine von der zweiten Strommodulationsstufe 236 umfasste siebte Ruhestromquelle 254 gebildet ist.

Auch die Sourceanschlüsse der Transistoren, mit denen die sechste und die siebte Ruhestromquelle 253, 254 gebildet sind, sind mit dem das erste Versorgungsspannungspotential VDD führenden ersten Versorgungsspannungsanschluss 229 verbunden.

Entsprechend sind die Gateanschlüsse der Transistoren, mit denen die sechste und die siebte Ruhestromquelle 253, 254 gebildet sind, mit einem gemeinsamen Steuerspannungsanschluss 256 verbunden, über den der sechsten und der siebten Ruhestromquelle 253, 254 im Betrieb eine gemeinsame Steuerspannung zum Einstellen eines, insbesondere übereinstimmenden, Ruhestroms in der sechsten und der siebten Ruhestromquelle 253, 254 zugeführt wird. Die sechste und die siebte Ruhestromquelle 253, 254 weisen somit eine gemeinsame Ruhestromeinstellung durch die gemeinsame Steuerspannung an den Gateanschlüssen auf.

Alle Transistoren in der ersten und der zweiten Strommodulationsstufe 235 und 236 sind im Ausführungsbeispiel nach Fig. 2 als PMOS-Feldeffekttransistoren ausgebildet.

Die beiden Differenzstufen 237, 238 bzw. 239, 240 jeder der Strommodulationsstufen 235 bzw. 236 werden durch Steuersignale an den Gateanschlüssen der sourcegekoppelten Transistoren 241, 242 bzw. 243, 244 bzw. 245, 246 bzw. 247, 248 der Differenzstufen 237 bzw. 238 bzw. 239 bzw. 240 gesteuert.

Bei diesen Steuersignalen an den Gateanschlüssen der sourcegekoppelten Transistoren 241, 242 bzw. 243, 244 bzw. 245, 246 bzw. 247, 248 handelt es sich vorzugsweise um diskretisierte Steuersignale, die bevorzugt von einem digitalen Phasendetektor zuführbar sind.

Die Steuersignale aus dem Phasendetektor bestehen üblicherweise aus einem diskretisierten Signal zur Frequenzerhöhung (in Fig. 2 ausgeführt als differenzielles Signal up/upb, mit upb = komplementäres Signal zu up), sowie einem diskretisierten Signal zur Frequenzreduzierung (in Fig. 2 ausgeführt als differenzielles Signal dn/dnb, mit dnb = komplementäres Signal zu dn).

Insbesondere wird im Ausführungsbeispiel nach Fig. 2 dem Gateanschluss des
- ersten sourcegekoppelten Transistors 241 der ersten Differenzstufe 237 der ersten Strommodulationsstufe 235 das differenzielle Signal up zur Frequenzerhöhung,
- zweiten sourcegekoppelten Transistors 242 der ersten Differenzstufe 237 der ersten Strommodulationsstufe 235 das komplementäre differenzielle Signal upb zur Frequenzerhöhung,
- ersten sourcegekoppelten Transistors 243 der zweiten Differenzstufe 238 der ersten Strommodulationsstufe 235 das differenzielle Signal dn zur Frequenzreduzierung,
- zweiten sourcegekoppelten Transistors 244 der zweiten Differenzstufe 238 der ersten Strommodulationsstufe 235 das komplementäre differenzielle Signal dnb zur Frequenzreduzierung,
- ersten sourcegekoppelten Transistors 245 der ersten Differenzstufe 239 der zweiten Strommodulationsstufe 236 das differenzielle Signal up zur Frequenzerhöhung,
- zweiten sourcegekoppelten Transistors 246 der ersten Differenzstufe 239 der zweiten Strommodulationsstufe 236 das komplementäre differenzielle Signal upb zur Frequenzerhöhung,
- ersten sourcegekoppelten Transistors 247 der zweiten Differenzstufe 240 der zweiten Strommodulationsstufe 236 das differenzielle Signal dn zur Frequenzreduzierung und
- zweiten sourcegekoppelten Transistors 248 der zweiten Differenzstufe 240 der zweiten Strommodulationsstufe 236 das komplementäre differenzielle Signal dnb zur Frequenzreduzierung
zugeführt.

Die gemeinsame Steuerspannung bzw. gemeinsamen Steuerspannungen an den gemeinsamen Steuerspannungsanschlüssen 255 bzw. 256 ist bzw. sind von den für die Ruhestromeinstellungen der Ruhestromquellen 212, 218, 223 für das erste, zweite bzw. dritte Differenzpaar 209, 215 bzw. 220 den Gateanschlüssen der die Ruhestromquellen 212, 218 bzw 223 bildenden NMOS-Feldeffekttransistoren zuzuführenden Steuerspannungen unabhängig wählbar.

Dies und voneinander unabhängige Dimensionierungen der Transistoren der ersten bis dritten Ruhestromquelle 212, 218, 223 und der Transistoren der vierten bis siebten Ruhestromquelle 251, 252, 253, 254 ermöglichen es, die Ruheströme der vierten bis siebten Ruhestromquelle 251, 252, 253, 254 von den Ruheströmen der ersten bis dritten Ruhestromquelle 212, 218, 223 unabhängig einzustellen, zum Beispiel auf geringere Stromstärken.

Im Betrieb des Ringoszillators 100 bzw. der Verzögerungsstufe 200 werden, gesteuert durch das Signal zur Frequenzerhöhung up/upb und das Signal zur Frequenzreduzierung dn/dnb, die Ruheströme der vierten bis siebten Ruhestromquelle 251, 252, 253, 254 wahlweise in den fünften Verbindungspunkt 249 der gekoppelten Sourceanschlüsse des ersten sourcegekoppelten Transistors 210 und des zweiten sourcegekoppelten Transistors 211 des ersten Differenzpaars 209 der ersten Signalübertragungsstufe 208 mit der ersten Ruhestromquelle 212 zum ersten Differenzpaar 209 der ersten Signalübertragungsstufe 208 bzw. in den sechsten Verbindungspunkt 250 der gekoppelten Sourceanschlüsse des ersten sourcegekoppelten Transistors 221 und des zweiten sourcegekoppelten Transistors 222 des dritten Differenzpaars 220 der internen Verzögerungsstufe 219 mit der dritten Ruhestromquelle 223 zum dritten Differenzpaar 220 der internen Verzögerungsstufe 219 eingespeist.

Hierdurch erfolgt eine - gegenüber den Ruheströmen der ersten und der dritten Ruhestromquelle 212, 223 vorzugsweise geringfügige - Änderung der Ruheströme der ersten bzw. der dritten Ruhestromquelle 212 bzw. 223 vom ersten Differenzpaar 209 der sourcegekoppelten Transistoren 210, 211 bzw. vom dritten Differenzpaar 220 der sourcegekoppelten Transistoren 221, 222 durch mindestens eine der vierten bis siebten Ruhestromquellen 251, 252, 253, 254.

Dies entspricht einer Strommodulation an den gekoppelten Sourceanschlüssen der Transistoren 210, 211 bzw. 221, 222, hervorgerufen durch die Signale zur Frequenzerhöhung up/upb bzw. zur Frequenzreduzierung dn/dnb, das heißt die in den gekoppelten Sourceanschlüssen der Transistoren 210, 211 bzw. 221, 222 im Resultat fließenden Ruheströme werden, vorzugsweise geringfügig gegenüber den Ruheströmen der ersten bzw. der dritten Ruhestromquelle 212 bzw. 223, durch die Signale zur Frequenzerhöhung up/upb bzw. zur Frequenzreduzierung dn/dnb variiert.

Die Differenzstufen 237, 238 der ersten Strommodulationsstufe 235 und die Differenzstufen 239, 240 der zweiten Strommodulationsstufe 236 sorgen auf diese Weise für eine geringfügige quantisierte, also sozusagen digitale Strommodulation und führen daher im Wesentlichen durch die mit dieser Strommodulation erzielte Modulation der Transkonduktanzen der sourcegekoppelten Transistoren 210, 211 im ersten Differenzpaar 209 bzw. der sourcegekoppelten Transistoren 221, 222 im dritten Differenzpaar 220 der internen Verzögerungsstufe 219 - und/oder im zweiten Differenzpaar 215 gemäß einer der vorbezeichneten Abwandlungen des Ausführungsbeispiels - zu einer Modulation der Verzögerung des Signals im ersten bzw. zweiten bzw. dritten Differenzpaar 209 bzw. 215 bzw. 220 und damit zu einer entsprechenden Modulation der Schwingfrequenz des Oszillators 100.

Diese Art der quantisierten Frequenzmodulation ist insbesondere mit Vorteil anwendbar bei CDRs mit digitalen Phasendetektoren. Die Steuersignale für die Baugruppen der ersten Strommodulationsstufe 235 für die erste Strommodulation und der zweiten Strommodulationsstufe 236 für die zweite Strommodulation werden aus dem Phasendetektor der CDR zugeführt.

Bei den erwähnten Steuersignalen up/upb, dn/dnb aus dem Phasendetektor werden drei Fälle [a], [b] und [c] unterschieden:

| | |
|---|---|
| Fall [a]: | Vornehmen einer Frequenzerhöhung gegenüber mittlerer Frequenz durch up=1 und dn=0; |
| Fall [b]: | Vornehmen einer Frequenzreduzierung gegenüber mittlerer Frequenz durch up=0 und dn=1; |
| Fall [c]: | Beibehalten der mittleren Frequenz durch up=0 und dn=0. |

### - zu Fall [a]:

Die erste Differenzstufe 237, der das Signal zur Frequenzerhöhung up/upb zugeführt wird, sowie die zweite Differenzstufe 238, der das Signal zur Frequenzreduzierung dn/dnb zugeführt wird, der ersten Strommodulationsstufe 235 speisen keinen Strom in die Ruhestromeinstellung des ersten Differenzpaares 209 der sourcegekoppelten Transistoren 210, 211 ein.

Somit steht der ganze Ruhestrom der ersten Ruhestromquelle 212 dem ersten Differenzpaar 209 zur Verfügung, die Transkonduktanz der sourcegekoppelten Transistoren 210, 211 des ersten Differenzpaares 209 ist maximiert, was sich in maximierter Schwingfrequenz des Oszillatorringes, das heißt des Ringoszillators 100, äußert.

Gleiches gilt für die Auswirkung der ersten und zweiten Differenzstufe 239 bzw. 240, denen ebenfalls das Signal zur Frequenzerhöhung up/upb sowie das Signal zur Frequenzreduzierung dn/dnb zugeführt wird, der zweiten Strommodulationsstufe 236 auf die Ruhestromeinstellung der internen Verzögerungsstufe 219.

### - zu Fall [b]:

Die erste und die zweite Differenzstufe 237, 238, die wiederum mit dem Signal zur Frequenzerhöhung up/upb sowie dem Signal zur Frequenzreduzierung dn/dnb angesteuert werden, der ersten Strommodulationsstufe 235 speisen über den ersten sourcegekoppelten Transistor 241 der ersten Differenzstufe 237 und den zweiten sourcegekoppelten Transistor 244 der zweiten Differenzstufe 238 jeweils einen zusätzlichen Strom, das heißt die Ruheströme der vierten Ruhestromquelle 251 und der fünfen Ruhestromquelle 252, in die Ruhestromeinstellung des ersten Differenzpaares 209 der sourcegekoppelten Transistoren 210, 211 ein.

Somit wird der Ruhestrom des ersten Differenzpaares 209 um diesen Strom, das heißt um die Stromsumme aus den Ruheströmen der vierten Ruhestromquelle 251 und der fünfen Ruhestromquelle 252, verringert, die Transkonduktanz des ersten Differenzpaares 209 ist reduziert, was sich in reduzierter Schwingfrequenz des Oszillatorringes 100 äußert.

Gleiches gilt für die Auswirkung der ersten und zweiten Differenzstufe 239 bzw. 240, denen ebenfalls das Signal zur Frequenzerhöhung up/upb sowie das Signal zur Frequenzreduzierung dn/dnb zugeführt wird, der zweiten Strommodulationsstufe 236 auf die Ruhestromeinstellung der internen Verzögerungsstufe 219.

### - zu Fall [c]:

Die erste Differenzstufe 237 wird wiederum mit dem Signal zur Frequenzerhöhung up/upb angesteuert. Die erste Strommodulationsstufe 235 speist über den ersten sourcegekoppelten Transistor 241 der ersten Differenzstufe 237 einen zusätzlichen Strom, das heißt den Ruhestrom der vierten Ruhestromquelle 251, in die Ruhestromeinstellung des ersten Differenzpaares 209 der sourcegekoppelten Transistoren 210, 211 ein, die mit dem Signal zur Frequenzreduzierung dn/dnb angesteuerte zweite Differenzstufe 238 hingegen nicht.

Daher stellt sich für die Ruhestromeinstellung des ersten Differenzpaares 209 der sourcegekoppelten Transistoren 210, 211 eine Situation auf halbem Wege zwischen den Fällen [a] und [b] ein, was zur Einstellung einer mittleren Oszillatorfrequenz führt.

Gleiches gilt für die Auswirkung der ersten und zweiten Differenzstufe 239 bzw. 240, denen ebenfalls das Signal zur Frequenzerhöhung up/upb sowie das Signal zur Frequenzreduzierung dn/dnb zugeführt werden, der zweiten Strommodulationsstufe 236 auf die Ruhestromeinstellung der internen Verzögerungsstufe.

Ein wesentlicher Vorteil der vorliegenden Erfindung ist darin zu sehen, dass keine parasitären Kapazitäten, insbesondere keine parasitären kapazitiven Lasten, durch das Einfügen frequenzvariierender Elemente in den Signalpfad des Oszillators auftreten.

Ein weiterer Vorteil besteht darin, dass durch Variation der Ruhestromeinstellungen der ersten Strommodulationsstufe 235 und der zweiten Strommodulationsstufe 236 die Höhe der Frequenzmodulation in einem relativ großen Bereich eingestellt werden kann.

Da zum Beispiel bei Anwendung in einer CDR (= Clock and/or Data Recovery = Takt- und/oder Datenrückgewinnung) die Höhe der Frequenzmodulation die Bandbreite der CDR bestimmt, kann so ohne weitere Eingriffe im Signalpfad des Ozillators 100, der empfindlich auf zusätzliche parasitäre Elemente reagiert, zusätzlich die Bandbreite einer CDR variiert werden.

Im eingangs angeführten Stand der Technik wäre dies nur durch Hinzufügen weiterer Varaktoren in den Signalpfad möglich. Dies gelingt allerdings nicht, ohne zusätzliche parasitäre Verdrahtungskapazitäten hinzuzufügen, was die maximale Schwingfrequenz des Oszillators reduziert.

Hingegen werden bei der vorliegenden Erfindung kapazitive Lasten in den Signalübertragungspfaden vermieden oder zumindest verringert. Als Verzögerungsstufe in einem Ringoszillator ermöglicht die Vorrichtung gemäß der vorliegenden Erfindung höhere Schwingfrequenzen.

### Liste der Bezugszeichen

- 100: Oszillatorring oder Ringoszillator
- 200: Vorrichtung, insbesondere Verzögerungsstufe
- 201: differenzieller Eingang der Vorrichtung 200
- 202: Eingangsanschluss des differenziellen Eingangs 201
- 203: Eingangsanschluss des differenziellen Eingangs 201
- 204: differenzieller Ausgang der Vorrichtung 200
- 205: Ausgangsanschluss des differenziellen Ausgangs 204
- 206: Ausgangsanschluss des differenziellen Ausgangs 204
- 207: erster Signalübertragungspfad der Vorrichtung 200
- 208: erste Signalübertragungsstufe des ersten Signalübertragungspfads 207
- 209: erstes Differenzpaar der sourcegekoppelten Transistoren 210, 211 der ersten Signalübertragungsstufe 208
- 210: erster sourcegekoppelter Transistor des ersten Differenzpaars 209
- 211: zweiter sourcegekoppelter Transistor des ersten Differenzpaars 209
- 212: gemeinsame einstellbare erste Ruhestromquelle der ersten Signalübertragungsstufe 208 zum ersten Differenzpaar 209
- 213: zweiter Signalübertragungspfad der Vorrichtung 200
- 214: zweite Signalübertragungsstufe des zweiten Signalübertragungspfads 213
- 215: zweites Differenzpaar der sourcegekoppelten Transistoren 216, 217 der zweiten Signalübertragungsstufe 214
- 216: erster sourcegekoppelter Transistor des zweiten Differenzpaars 215
- 217: zweiter sourcegekoppelter Transistor des zweiten Differenzpaars 215
- 218: gemeinsame einstellbare zweite Ruhestromquelle der zweiten Signalübertragungsstufe 214 zum zweiten Differenzpaar 215
- 219: interne Verzögerungsstufe des zweiten Signalübertragungspfads 213
- 220: drittes Differenzpaar der sourcegekoppelten Transistoren 221, 222 der internen Verzögerungsstufe 219
- 221: erster sourcegekoppelter Transistor des dritten Differenzpaars 220
- 222: zweiter sourcegekoppelter Transistor des dritten Differenzpaars 220
- 223: gemeinsame einstellbare dritte Ruhestromquelle der internen Verzögerungsstufe 219 zum dritten Differenzpaar 220
- 224: Signalverknüpfungsstufe der Vorrichtung 200, ausgebildet mit einer für das erste Differenzpaar 209 und das zweite Differenzpaar 215 gemeinsamen resistiven Last
- 225: erster Arbeitswiderstand, von gemeinsamer resistiver Last in der Signalverknüpfungsstufe 224 umfasst
- 226: zweiter Arbeitswiderstand, von gemeinsamer resistiver Last in der Signalverknüpfungsstufe 224 umfasst
- 227: erster Verbindungspunkt der Drainanschlüsse des ersten sourcegekoppelten Transistors 210, 216, insbesondere Stromknoten für additive Überlagerung der Ströme in Drainanschlüssen des ersten sourcegekoppelten Transistors 210, 216
- 228: zweiter Verbindungspunkt der Drainanschlüsse des zweiten sourcegekoppelten Transistors 211, 217, insbesondere Stromknoten für additive Überlagerung der Ströme in Drainanschlüssen des zweiten sourcegekoppelten Transistors 211, 217
- 229: erster Versorgungsspannungsanschluss, führt erstes Versorgungsspannungspotential VDD
- 230: dritter Arbeitswiderstand in interner Verzögerungsstufe 219
- 231: vierter Arbeitswiderstand in interner Verzögerungsstufe 219
- 232: dritter Verbindungspunkt des Drainanschlusses des ersten sourcegekoppelten Transistors 221 und des Gateanschlusses des ersten sourcegekoppelten Transistors 216
- 233: vierter Verbindungspunkt des Drainanschlusses des zweiten sourcegekoppelten Transistors 222 und des Gateanschlusses des zweiten sourcegekoppelten Transistors 217
- 234: zweiter Versorgungsspannungsanschluss, führt zweites Versorgungsspannungspotential VSS
- 235: erste Strommodulationsstufe zum Einstellen des Ruhestroms der ersten Ruhestromquelle 212
- 236: zweite Strommodulationsstufe zum Einstellen des Ruhestroms der dritten Ruhestromquelle 223
- 237: erste Differenzstufe der sourcegekoppelten Transistoren 241, 242 der ersten Strommodulationsstufe 235
- 238: zweite Differenzstufe der sourcegekoppelten Transistoren 243, 244 der ersten Strommodulationsstufe 235
- 239: erste Differenzstufe der sourcegekoppelten Transistoren 245, 246 der zweiten Strommodulationsstufe 236
- 240: zweite Differenzstufe der sourcegekoppelten Transistoren 247, 248 der zweiten Strommodulationsstufe 236
- 241: erster sourcegekoppelter Transistor der ersten Differenzstufe 237
- 242: zweiter sourcegekoppelter Transistor der ersten Differenzstufe 237
- 243: erster sourcegekoppelter Transistor der zweiten Differenzstufe 238
- 244: zweiter sourcegekoppelter Transistor der zweiten Differenzstufe 238
- 245: erster sourcegekoppelter Transistor der ersten Differenzstufe 239
- 246: zweiter sourcegekoppelter Transistor der ersten Differenzstufe 239
- 247: erster sourcegekoppelter Transistor der zweiten Differenzstufe 240
- 248: zweiter sourcegekoppelter Transistor der zweiten Differenzstufe 240
- 249: fünfter Verbindungspunkt der gekoppelten Sourceanschlüsse des ersten sourcegekoppelten Transistors 210 und des zweiten sourcegekoppelten Transistors 211 mit erster Ruhestromquelle 212
- 250: sechster Verbindungspunkt der gekoppelten Sourceanschlüsse des ersten sourcegekoppelten Transistors 221 und des zweiten sourcegekoppelten Transistors 222 mit dritter Ruhestromquelle 223
- 251: vierte Ruhestromquelle der ersten Strommodulationsstufe 235 zu erster Differenzstufe 237
- 252: fünfte Ruhestromquelle der ersten Strommodulationsstufe 235 zu zweiter Differenzstufe 238
- 253: sechste Ruhestromquelle der zweiten Strommodulationsstufe 236 zu erster Differenzstufe 239
- 254: siebte Ruhestromquelle der zweiten Strommodulationsstufe 236 zu zweiter Differenzstufe 240
- 255: gemeinsamer Steuerspannungsanschluss der vierten Ruhestromquelle 251 und der fünften Ruhestromquelle 252
- 256: gemeinsamer Steuerspannungsanschluss der sechsten Ruhestromquelle 253 und der siebten Ruhestromquelle 254
- dn: differenzielles diskretisiertes Signal zur Frequenzreduzierung am ersten sourcegekoppelten Transistor 243, 247
- dnb: zum differenziellen diskretisierten Signal dn komplementäres Signal am zweiten sourcegekoppelten Transistor 244, 248
- up: differenzielles diskretisiertes Signal zur Frequenzerhöhung am ersten sourcegekoppelten Transistor 241, 245
- upb: zum differenziellen diskretisierten Signal up komplementäres Signal am zweiten sourcegekoppelten Transistor 242, 246
- VDD: erstes, insbesondere gegenüber zweitem Versorgungsspannungspotential VSS positives, Versorgungsspannungspotential an erstem Versorgungsspannungsanschluss 229
- VSS: zweites Versorgungsspannungspotential, insbesondere Massepotential, an zweitem Versorgungsspannungsanschluss 234

## Patentansprüche

1. Vorrichtung (200) zum steuerbaren Verzögern eines elektrischen Signals
- mit einem ersten Signalübertragungspfad (207) zwischen einem Signaleingang (201) und einem Signalausgang (204), aufweisend
- - eine erste Signalübertragungsstufe (208) mit einem ersten Differenzpaar (209) und einer gemeinsamen, einstellbaren ersten Ruhestromquelle (212),
- mit einem zweiten Signalübertragungspfad (213) zwischen dem Signaleingang (201) und dem Signalausgang (204), aufweisend
- - eine zweite Signalübertragungsstufe (214) mit einem zweiten Differenzpaar (215) und einer gemeinsamen, einstellbaren zweiten Ruhestromquelle (218) sowie
- - eine zwischen dem Signaleingang (201) und der zweiten Signalübertragungsstufe (214) angeordnete interne Verzögerungsstufe (219) mit einem dritten Differenzpaar (220) und einer gemeinsamen, einstellbaren dritten Ruhestromquelle (223), und
- mit einer Signalverknüpfungsstufe (224) zum additiven Überlagern des über den ersten Signalübertragungspfad (207) übertragenen elektrischen Signals mit dem über den zweiten Signalübertragungspfad (213) übertragenen elektrischen Signal,
**dadurch gekennzeichnet,**
**dass** eine erste Strommodulationsstufe (235) zum Einstellen des Ruhestroms der ersten Ruhestromquelle (212), nämlich zum Einspeisen eines zusätzlichen Stroms in eine Ruhestromeinstellung der ersten Ruhestromquelle (212), und eine zweite Strommodulationsstufe (236) zum Einstellen des Ruhestroms der dritten Ruhestromquelle (223), nämlich zum Einspeisen eines zusätzlichen Stroms in eine Ruhestromeinstellung der dritten Ruhestromquelle (223), jeweils
- mit einer ersten Differenzstufe (237; 239) und einer der ersten Differenzstufe (237; 239) gemeinsamen, einstellbaren ersten Strommodulations-Ruhestromquelle (251; 253) und
- mit einer zweiten Differenzstufe (238; 240) und einer der zweiten Differenzstufe (238; 240) gemeinsamen, einstellbaren zweiten Strommodulations-Ruhestromquelle (252; 254)
ausgebildet sind, wobei
- der ersten Differenzstufe (237; 239) als ein erstes Steuersignal ein diskretisiertes Signal zur Frequenzerhöhung (up/upb) eines die mindestens eine Vorrichtung (200) aufweisenden Oszillatorrings (100) und
- der zweiten Differenzstufe (238; 240) als ein zweites Steuersignal ein diskretisiertes Signal zur Frequenzreduzierung (dn/dnb) des Oszillatorrings (100)
zuführbar ist und
- die erste (251; 253) und die zweite (252; 254) Strommodulations-Ruhestromquelle jeder Strommodulationsstufe (235; 236) gemeinsam einstellbar sind.

2. Vorrichtung gemäß Anspruch 1, **dadurch gekennzeichnet, dass**
- das erste Differenzpaar (209) mindestens zwei emitter- bzw. sourcegekoppelte Transistoren (210, 211) und
- das zweite Differenzpaar (215) mindestens zwei emitter- bzw. sourcegekoppelte Transistoren (216, 217) und
- das dritte Differenzpaar (220) mindestens zwei emitter- bzw. sourcegekoppelte Transistoren (221, 222) aufweist.

3. Vorrichtung gemäß Anspruch 1 oder 2, **gekennzeichnet durch** eine dritte Strommodulationsstufe zum Einstellen des Ruhestroms der zweiten Ruhestromquelle (218).

4. Vorrichtung gemäß Anspruch 3, **dadurch gekennzeichnet, dass** die dritte Strommodulationsstufe zum Einspeisen eines zusätzlichen Stroms in die Ruhestromeinstellung der zweiten (218) Ruhestromquelle ausgebildet ist.

5. Vorrichtung gemäß Anspruch 3 oder 4, **dadurch gekennzeichnet, dass** in der dritten Strommodulationsstufe jeweils die erste und die zweite Strommodulations-Ruhestromquelle zum durch das erste (up/upb) und zweite (dn/dnb) Steuersignal gesteuerten Einspeisen des jeweils zusätzlichen Stroms in eine Ruhestromeinstellung der zweiten (218) Ruhestromquelle ausgebildet sind.

6. Vorrichtung gemäß mindestens einem der Ansprüche 1 bis 5, **dadurch gekennzeichnet, dass**
- die erste Differenzstufe (237; 239) ein erstes Strommodulations-Differenzpaar und
- die zweite Differenzstufe (238; 240) ein zweites Strommodulations-Differenzpaar aufweist.

7. Vorrichtung gemäß mindestens einem der Ansprüche 1 bis 6, **dadurch gekennzeichnet, dass**
- die erste Differenzstufe (237; 239) mindestens zwei emitter- bzw. sourcegekoppelte Transistoren (241, 242; 245, 246) und
- die zweite Differenzstufe (238; 240) mindestens zwei emitter- bzw. sourcegekoppelte Transistoren (243, 244; 247, 248)
aufweist.

8. Vorrichtung gemäß mindestens einem der Ansprüche 1 bis 7, **dadurch gekennzeichnet, dass**
- die erste Strommodulations-Ruhestromquelle mindestens eine vierte (251) bzw. sechste (253) Ruhestromquelle und/oder
- die zweite Strommodulations-Ruhestromquelle mindestens eine fünfte (252) bzw. siebte (254) Ruhestromquelle
aufweist.

9. Vorrichtung gemäß mindestens einem der Ansprüche 1 bis 8, **dadurch gekennzeichnet, dass** in der ersten (235) bzw. zweiten (236) Strommodulationsstufe jeweils die erste (251; 253) und die zweite (252; 254) Strommodulations-Ruhestromquelle zum durch das erste (up/upb) und zweite (dn/dnb) Steuersignal gesteuerten Einspeisen des jeweils zusätzlichen Stroms in die jeweilige Ruhestromeinstellung der ersten (212) bzw. dritten (223) Ruhestromquelle ausgebildet sind.

10. Vorrichtung gemäß mindestens einem der Ansprüche 1 bis 9, **gekennzeichnet**
- **durch** ein erstes Versorgungsspannungspotential (VDD) an einem ersten Versorgungsspannungsanschluss (229) und
- **durch** ein zweites Versorgungsspannungspotential (VSS) an einem zweiten Versorgungsspannungsanschluss (234).

11. Vorrichtung gemäß Anspruch 10, **dadurch gekennzeichnet,**
- **dass** das zweite Versorgungsspannungspotential (VSS) Massepotential ist und/oder
- **dass** das erste Versorgungsspannungspotential (VDD) gegenüber dem zweiten Versorgungsspannungspotential (VSS) positiv ist.

12. Oszillatorring (100), aufweisend mindestens eine Vorrichtung (200) gemäß mindestens einem der Ansprüche 1 bis 11.

13. Verfahren zum Steuern des Verzögerns eines elektrischen Signals sowie zu diesem Verzögern des elektrischen Signals mit mindestens einer Vorrichtung (200) gemäß mindestens einem der Ansprüche 1 bis 11,
**dadurch gekennzeichnet,**
- **dass** der ersten Strommodulationsstufe (235) und der zweiten Strommodulationsstufe (236) jeweils
- - ein diskretisiertes Signal zur Frequenzerhöhung (up/upb) mindestens eines Oszillatorrings (100) gemäß Anspruch 12 als ein erstes Steuersignal und
- - ein diskretisiertes Signal zur Frequenzreduzierung (dn/dnb) des Oszillatorrings (100) als ein zweites Steuersignal
zugeführt werden/wird,
- gesteuert durch das erste (up/upb) und zweite (dn/dnb) Steuersignal, in der ersten (235) und zweiten (236) Strommodulationsstufe jeweils ein zusätzlicher Strom erzeugt wird und
- der jeweils zusätzliche Strom der ersten (235) und zweiten (236) Strommodulationsstufe in eine Ruhestromeinstellung der ersten (212) bzw. dritten (223) Ruhestromquelle eingespeist wird zum Einstellen des Ruhestroms der ersten (212) bzw. dritten (223) Ruhestromquelle.

14. Verwendung mindestens einer Vorrichtung (200) gemäß mindestens einem der Ansprüche 1 bis 11 und/oder eines Verfahrens gemäß Anspruch 13 bei der Takt- und/oder Datenrückgewinnung mit mindestens einem digitalen Phasendetektor, wobei vom mindestens einen digitalen Phasendetektor ein diskretisiertes Signal zur Frequenzerhöhung (up/upb) mindestens eines Oszillatorrings (100) gemäß Anspruch 12 als ein erstes Steuersignal und ein diskretisiertes Signal zur Frequenzreduzierung(dn/dnb) des Oszillatorrings (100) als ein zweites Steuersignal zugeführt werden/wird.

## Claims

1. A device (200) for controllably delaying an electrical signal,
- with a first signal transfer path (207) between a signal input (201) and a signal output (204), comprising
- - a first signal transfer stage (208) with a first differential pair (209) and a common, adjustable first quiescent current source (212),
- with a second signal transfer path (213) between the signal input (201) and the signal output (204), comprising
- - a second signal transfer stage (214) with a second differential pair (215) and a common, adjustable second quiescent current source (218), and
- - an internal delay stage (219), arranged between the signal input (201) and the second signal transfer stage (214) and having a third differential pair (220) and a common, adjustable third quiescent current source (223), and
- with a signal combination stage (224) for additively superimposing the electrical signal transferred via the first signal transfer path (207) on to the electrical signal transferred via the second signal transfer path (213), **characterized in**
**that** a first current modulation stage (235) for adjusting the quiescent current of the first quiescent current source (212), namely for feeding an additional current into a quiescent current setting of the first quiescent current source (212), and a second current modulation stage (236) for adjusting the quiescent current of the third quiescent current source (223), namely for feeding an additional current into a quiescent current setting of the third quiescent current source (223), are respectively designed
- with a first differential stage (237; 239) and an adjustable first current modulation quiescent current source (251; 253) common to the first differential stage (237; 239), and
- with a second differential stage (238; 240) and an adjustable second current modulation quiescent current source (252; 254) common to the second differential stage (238; 240), wherein
- the first differential stage (237; 239) is providable with, as a first control signal, a discretized signal for frequency increase (up/upb) of an oscillator ring (100) comprising the at least one device (200), and
- the second differential stage (238; 240) is providable with, as a second control signal, a discretized signal for frequency reduction (dn/dnb) of the oscillator ring (100)
and
- the first (251; 253) and the second (252; 254) current modulation quiescent current source of each current modulation stage (235; 236) are commonly adjustable.

2. The device according to claim 1, **characterized in that**
- the first differential pair (209) comprises at least two emitter- or source-coupled transistors (210, 211) and
- the second differential pair (215) comprises at least two emitter- or source-coupled transistors (216, 217) and
- the third differential pair (220) comprises at least two emitter- or source-coupled transistors (221, 222).

3. The device according to claim 1 or 2, **characterized by** a third current modulation stage for adjusting the quiescent current of the second quiescent current source (218).

4. The device according to claim 3, **characterized in that** the third current modulation stage is designed for feeding an additional current into the quiescent current setting of the second (218) quiescent current source.

5. The device according to claim 3 or 4, **characterized in that** in the third current modulation stage respectively the first and the second current modulation quiescent current source are designed for feeding the respectively additional current, controlled by the first (up/upb) and second (dn/dnb) control signal, into a quiescent current setting of the second (218) quiescent current source.

6. The device according to at least one of claims 1 to 5, **characterized in that**
- the first differential stage (237; 239) comprises a first current modulation difference pair, and
- the second differential stage (238; 240) comprises a second current modulation difference pair.

7. The device according to at least one of claims 1 to 6, **characterized in that**
- the first differential stage (237; 239) comprises at least two emitter- or source-coupled transistors (241, 242; 245, 246), and
- the second differential stage (238; 240) comprises at least two emitter- or source-coupled transistors (243, 244; 247, 248).

8. The device according to at least one of claims 1 to 7, **characterized in that**
- the first current modulation quiescent current source comprises at least one fourth (251) or sixth (253) quiescent current source and/or
- the second current modulation quiescent current source comprises at least one fifth (252) or seventh (254) quiescent current source.

9. The device according to at least one of claims 1 to 8, **characterized in that,** in the first (235) or second (236) current modulation stage, respectively, the first (251; 253) and the second (252; 254) current modulation quiescent current source are designed for feeding, controlled by the first (up/upb) and second (dn/dnb) control signal, the respectively additional current into the respective quiescent current setting of the first (212) or third (223) quiescent current source.

10. The device according to at least one of claims 1 to 9, **characterized**
- **by** a first supply voltage potential (VDD) at a first supply voltage terminal (229), and
- by a second supply voltage potential (VSS) at a second supply voltage terminal (234).

11. The device according to claim 10, **characterized in**
- **that** the second supply voltage potential (VSS) is ground potential, and/or
- **that** the first supply voltage potential (VDD) is positive compared to the second supply voltage potential (VSS).

12. An oscillator ring (100), comprising at least one device (200) according to at least one of claims 1 to 11.

13. A method for controlling the delaying of an electrical signal and for said delaying the electrical signal by at least one device (200) according to at least one of claims 1 to 11,
**characterized in that**
- the first current modulation stage (235) and the second current modulation stage (236) is respectively provided with,
- - as a first control signal, a discretized signal for frequency increase (up/upb) of at least one oscillator ring (100) according to claim 12, and
- - as a second control signal, a discretized signal for frequency reduction (dn/dnb) of the oscillator ring (100),
- controlled by the first (up/upb) and second (dn/dnb) control signal, in the first (235) and second (236) current modulation stage respectively an additional current is generated, and
- the respectively additional current of the first (235) and second (236) current modulation stage is fed into a quiescent current setting of the first (212) or third (223) quiescent current source for adjusting the quiescent current of the first (212) or third (223) quiescent current source.

14. A use of at least one device (200) according to at least one of claims 1 to 11 and/or of a method according to claim 13 in the clock and/or data recovery by at least one digital phase detector wherein from the at least one digital phase detector a discretized signal for frequency increase (up/upb) of at least one oscillator ring (100) according to claim 12 is provided as a first control signal and a discretized signal for frequency reduction (dn/dnb) of the oscillator ring (100) is provided as a second control signal.

## Revendications

1. Dispositif (200) de retardement contrôlable d'un signal électrique
- avec un premier trajet de transmission de signaux (207) entre une entrée de signaux (201) et une sortie de signaux (204), comportant
- - un premier niveau de transmission de signaux (208) comportant une première paire différentielle (209) et une première source de courant de repos (212) commune ajustable,
- avec un second trajet de transmission de signaux (213) entre l'entrée de signaux (201) et la sortie de signaux (204), comportant
- - un second niveau de transmission de signaux (214) comportant une deuxième paire différentielle (215) et une deuxième source de courant de repos (218) commune ajustable, ainsi qu'
- - un niveau de retardement interne (219) agencé entre l'entrée de signaux (201) et le second niveau de transmission de signaux (214), comportant une troisième paire différentielle (220) et une troisième source de courant de repos (223) commune ajustable, et
- avec un niveau de concaténation de signaux (224) pour la superposition additive du signal électrique transmis sur le premier trajet de transmission de signaux (207) avec le signal électrique transmis sur le second trajet de transmission de signaux (213),
**caractérisé en ce**
**qu'** un premier niveau de modulation du courant (235) servant à ajuster le courant de repos de la première source de courant de repos (212), à savoir pour l'injection d'un courant supplémentaire dans un ajustement de courant de repos de la première source de courant de repos (212), et un deuxième niveau de modulation du courant (236) servant à ajuster le courant de repos de la troisième source de courant de repos (223), à savoir pour l'injection d'un courant supplémentaire dans un ajustement de courant de repos de la troisième source de courant de repos (223), sont chacun constitués :
- avec un premier niveau différentiel (237 ; 239) et une première source de courant de repos de modulation du courant (251 ; 253) commune au premier niveau différentiel (237 ; 239) et ajustable, et
- avec un second niveau différentiel (238 ; 240) et une seconde source de courant de repos de modulation du courant (252 ; 254) commune au second niveau différentiel (238 ; 240) et ajustable, dans lequel
- un signal discrétisé d'augmentation de fréquence (up/upb) d'un anneau oscillateur (100) comportant l'au moins un dispositif (200) peut être amené au premier niveau différentiel (237 ; 239) en tant que premier signal de commande, et
- un signal discrétisé de réduction de fréquence (dn/dnb) de l'anneau oscillateur (100) peut être amené au second niveau différentiel (238 ; 240) en tant que second signal de commande, et
- la première (251 ; 253) et la seconde (252 ; 254) source de courant de repos de modulation du courant de chaque niveau de modulation du courant (235 ; 236) sont ajustables en commun.

2. Dispositif selon la revendication 1, **caractérisé en ce que**
- la première paire différentielle (209) comporte au moins deux transistors à couplage d'émetteurs ou de sources (210, 211) et
- la deuxième paire différentielle (215) comporte au moins deux transistors à couplage d'émetteurs ou de sources (216, 217) et
- la troisième paire différentielle (220) comporte au moins deux transistors à couplage d'émetteurs ou de sources (221, 222).

3. Dispositif selon la revendication 1 ou 2, **caractérisé par** un troisième niveau de modulation du courant servant à ajuster le courant de repos de la deuxième source de courant de repos (218).

4. Dispositif selon la revendication 3, **caractérisé en ce que** le troisième niveau de modulation du courant est conçu pour l'injection d'un courant supplémentaire dans l'ajustement de courant de repos de la deuxième source de courant de repos (218).

5. Dispositif selon la revendication 3 ou 4, **caractérisé en ce que,** dans le troisième niveau de modulation du courant, respectivement la première et la seconde source de courant de repos de modulation du courant sont conçues pour l'injection, commandée par le premier (up/upb) et le second (dn/dnb) signal de commande, du courant supplémentaire respectif dans un ajustement de courant de repos de la deuxième source de courant de repos (218).

6. Dispositif selon au moins l'une des revendications 1 à 5, **caractérisé en ce que**
- le premier niveau différentiel (237 ; 239) comporte une première paire différentielle de modulation du courant et
- le second niveau différentiel (238 ; 240) comporte une seconde paire différentielle de modulation du courant.

7. Dispositif selon au moins l'une des revendications 1 à 6, **caractérisé en ce que**
- le premier niveau différentiel (237 ; 239) comporte au moins deux transistors à couplage d'émetteurs ou de sources (241, 242 ; 245, 246) et
- le second niveau différentiel (238 ; 240) comporte au moins deux transistors à couplage d'émetteurs ou de sources (243, 244 ; 247, 248).

8. Dispositif selon au moins l'une des revendications 1 à 7, **caractérisé en ce que**
- la première source de courant de repos de modulation du courant comporte au moins une quatrième (251) ou sixième (253) source de courant de repos et/ou
- la seconde source de courant de repos de modulation du courant comporte au moins une cinquième (252) ou septième (254) source de courant de repos.

9. Dispositif selon au moins l'une des revendications 1 à 8, **caractérisé en ce que,** dans le premier (235) ou le deuxième (236) niveau de modulation du courant, respectivement la première (251 ; 253) et la seconde (252 ; 254) source de courant de repos de modulation du courant sont conçues pour l'injection, commandée par le premier (up/upb) et le second (dn/dnb) signal de commande, du courant supplémentaire respectif dans l'ajustement de courant de repos respectif de la première (212) ou de la troisième (223) source de courant de repos.

10. Dispositif selon au moins l'une des revendications 1 à 9, **caractérisé**
- **par** un premier potentiel de tension d'alimentation (VDD) au niveau d'une première borne de tension d'alimentation (229) et
- **par** un second potentiel de tension d'alimentation (VSS) au niveau d'une seconde borne de tension d'alimentation (234).

11. Dispositif selon la revendication 10, **caractérisé en ce**
- **que** le second potentiel de tension d'alimentation (VSS) est le potentiel de masse et/ou
- **que** le premier potentiel de tension d'alimentation (VDD) est positif par rapport au second potentiel de tension d'alimentation (VSS).

12. Anneau oscillateur (100), comportant au moins un dispositif (200) selon au moins l'une des revendications 1 à 11.

13. Procédé pour contrôler le retardement d'un signal électrique ainsi que pour ce retardement du signal électrique avec au moins un dispositif (200) selon au moins l'une des revendications 1 à 11, **caractérisé en ce que**
- au premier niveau de modulation du courant (235) et au deuxième niveau de modulation du courant (236), sont/est amenés respectivement :
- - un signal discrétisé d'augmentation de fréquence (up/upb) d'au moins un anneau oscillateur (100) selon la revendication 12 en tant que premier signal de commande et
- - un signal discrétisé de réduction de fréquence (dn/dnb) de l'anneau oscillateur (100) en tant que second signal de commande,
- commandé par le premier (up/upb) et le second (dn/dnb) signal de commande, un courant supplémentaire est généré respectivement dans le premier (235) et le deuxième (236) niveau de modulation du courant, et
- le courant supplémentaire respectif du premier (235) et du deuxième (236) niveau de modulation du courant est injecté dans un ajustement de courant de repos de la première (212) ou de la troisième (223) source de courant de repos pour ajuster le courant de repos de la première (212) ou de la troisième (223) source de courant de repos.

14. Utilisation d'au moins un dispositif (200) selon au moins l'une des revendications 1 à 11 et/oder d'un procédé selon la revendication 13 lors de la récupération d'horloge et/ou de données avec au moins un détecteur de phase numérique, dans laquelle un signal discrétisé d'augmentation de fréquence (up/upb) d'au moins un anneau oscillateur (100) selon la revendication 12 en tant que premier signal de commande et un signal discrétisé de réduction de fréquence (dn/dnb) de l'anneau oscillateur (100) en tant que second signal de commande sont/est amenés par l'au moins un détecteur de phase numérique.
